(19) Europäisches Patentamt / European Patent Office / Office européen des brevets

(11) **EP 4 468 606 B1**

(12) **EUROPEAN PATENT SPECIFICATION**

(45) Date of publication and mention
of the grant of the patent:
**18.03.2026 Bulletin 2026/12**

(21) Application number: **23305830.4**

(22) Date of filing: **25.05.2023**

(51) International Patent Classification (IPC):
***H03K 17/082*** (2006.01)   ***H03K 17/18*** (2006.01)

(52) Cooperative Patent Classification (CPC):
**H03K 17/082; H03K 17/18;** H03K 2217/0027

(54) **TEMPERATURE-COMPENSATED OVER-CURRENT DETECTION SYSTEM**

TEMPERATURKOMPENSIERTES ÜBERSTROMERKENNUNGSSYSTEM

SYSTÈME DE DÉTECTION DE SURINTENSITÉ À COMPENSATION DE TEMPÉRATURE

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(43) Date of publication of application:
**27.11.2024 Bulletin 2024/48**

(73) Proprietors:
• **Mitsubishi Electric R&D Centre Europe B.V.**
  **1119 NS  Schiphol Rijk Amsterdam (NL)**
  Designated Contracting States:
  **FR**
• **MITSUBISHI ELECTRIC CORPORATION**
  **Chiyoda-ku**
  **Tokyo 100-8310 (JP)**
  Designated Contracting States:
  **AL AT BE BG CH CY CZ DE DK EE ES FI GB GR HR HU IE IS IT LI LT LU LV MC ME MK MT NL NO PL PT RO RS SE SI SK SM TR**

(72) Inventors:
• **DEGRENNE, Nicolas**
  **35708 RENNES CEDEX 7 (FR)**
• **Quemener, Vincent**
  **35708 RENNES CEDEX 7 (FR)**

(74) Representative: **Plasseraud IP**
**104 Rue de Richelieu**
**CS92104**
**75080 Paris Cedex 02 (FR)**

(56) References cited:
**US-A1- 2012 224 288     US-A1- 2018 281 600**

## Description

### Technical Field

This disclosure pertains to the field of the protection of power semiconductor switches such as IGBTs or MOSFETs against over currents and damages caused by such over currents.

### Background Art

It is known to provide a measurement of the collector-emitter or drain-source current of a power semiconductor switch in order to detect occurrence of an over current.

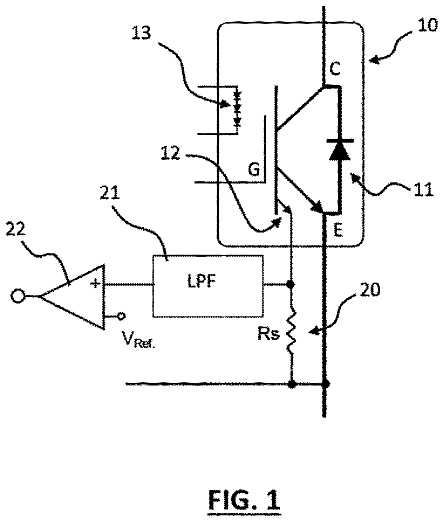

Monitoring the current through a power semiconductor switch such as IGBT or MOSFET is important to protect it from over-current or short-circuit (e.g. shoot-through) current. Several means to measure this current can be found in the literature. Monolithic current mirrors built-in the power dies or chips can provide a scaled value of the collector (or drain) current in a compact and reliable way and are implemented in several commercial products. Figure 1 shows an example of current measurement device for an IGBT 10 having a current mirror output 12 which gives a current signal proportional to the output current of the IGBT, e.g. 1/100 of the output current of the IGBT. The current measurement device comprises a sense resistor Rs, a low pass filter 21 and a comparator 22 having a reference voltage $V_{Ref}$ that corresponds to the current level not to be exceeded in the IGBT.

One limitation of built-in current sensors such as the current mirror output 12 is the dependency of the current ratio with the junction temperature Tj, which can reach sensitivities in the order of 1%/K. In the absence of any counter measure, chip temperature margins should be considered in the product design which decrease the ability to finely detect over-current and measure the correct current value.

Correction circuits are sometimes implemented in such power semiconductor switches or power modules built with such switches. However, such correction circuits and temperature sensors add cost and complexity to such power semiconductors and power modules.

An example of device comprising a temperature sensor is shown in document US2018/281600 A1 which concerns a fast switching circuit activated in case of small currents flowing through a semiconductor switch.

### Summary

This disclosure improves the situation and in particular addresses the problem to find an alternative method to correct the current sensor sensitivity to the junction temperature Tj when detection of an overcurrent is to be implemented.

A principle used in the present disclosure is to couple the built-in temperature-dependent current sensor and a temperature sensitive element of the die having a similar temperature curve than the current sensor of the semiconductor switch in order to compensate the temperature dependency of the current sensor and obtain a temperature independent overcurrent detection circuit.

More precisely the present disclosure proposes to provide *a semiconductor switch such as an IGBT or a MOSFET equipped with an overcurrent detection circuit as claimed in claim* 1.The following features may be optionally implemented, separately or in combination one with the others.

The temperature sensitive element being a gate resistor Rg of said semiconductor switch, the current source may be connected to said gate resistance Rg of said power semiconductor switch through an emitter or source of said semiconductor switch, in a way that said reference current $i_R$ flows during said at least dedicated period of measurement through said gate resistance Rg to provide said reference voltage Ve, said comparator, comparing said reference voltage Ve and said mirror voltage Vs.

The current source may be configured in parallel with a switch in order to shunt said current source with a command signal line providing a command signal $V_{SI}$ to inhibit flowing of said reference current $i_R$ in said gate resistor outside of said dedicated period of measurement, said dedicated period being made of a pulse within a ON period of the semiconductor switch driven by a driver voltage $V_{driver}$.

The measurement resistor Rs may be connected to the low voltage level of the driver voltage source through a capacitor Cs forming a charging circuit provided to generate the mirror voltage Vs with a trapezoidal voltage shape having a positive voltage ramp lower than the gate voltage Vg, said charging circuit comprising a reset switch connected to said charging circuit to discharge said capacitor Cs and connected to said command signal line.

The detection circuit may comprise a logic gate receiving a detection signal Ocd and a measurement inhibition signal line providing an inhibition signal to inhibit false detections outside of said dedicated measurement period, said logic gate providing an overcurrent detection logic signal TI-OCD.

The measurement inhibition signal line may be said command signal line.

The overcurrent detection circuit may be connected to an overcurrent detection input of said command circuit, said command circuit being configured to switch OFF said semiconductor switch upon occurrence of an overcurrent.

The signal line may be issued from a switching controller for the power switch.

**Brief Description of Drawings**

Other features, details and advantages will be shown in the following detailed description and on the figures, on which:

Figure 1 is an example of semiconductor power switch with built in current sensor and current measurement circuit;

Figure 2 is a schematic of a first example of realization of an overcurrent detection circuit according the disclosure;

Figure 3 is a schematic of a second example of realization of an overcurrent detection circuit according the disclosure;

Figure 4 is a schematic of a third example of realization of an overcurrent detection circuit according the disclosure;

Figure 5A is a schematic representation of signals of the first example of realization;

Figure 5B is a schematic representation of signals of the second example of realization;

Figure 6 is a resulting curve of the first example of realization.

**Description of examples**

In a power switch such as in figure 1 the current sensor output $i_s$ is a function of the collector current ic and of the junction temperature Tj. For some commercial component, the relation is well expressed by e.g., the following expression:

$$i_s = A \cdot i_c + B \cdot Tj \cdot i_c \text{ with } Vs = Rs \cdot i_s$$

A and B being two parameter characteristics of the built-in current source for a given sense resistor Rs value. Furthermore, the internal gate resistance of a switch is known to vary e.g. according to:

$$Rg = R_0 + \alpha \cdot Tj$$

with $R_0$ and $\alpha$ parameter characteristics of the die. Note that these values may be changed by design.

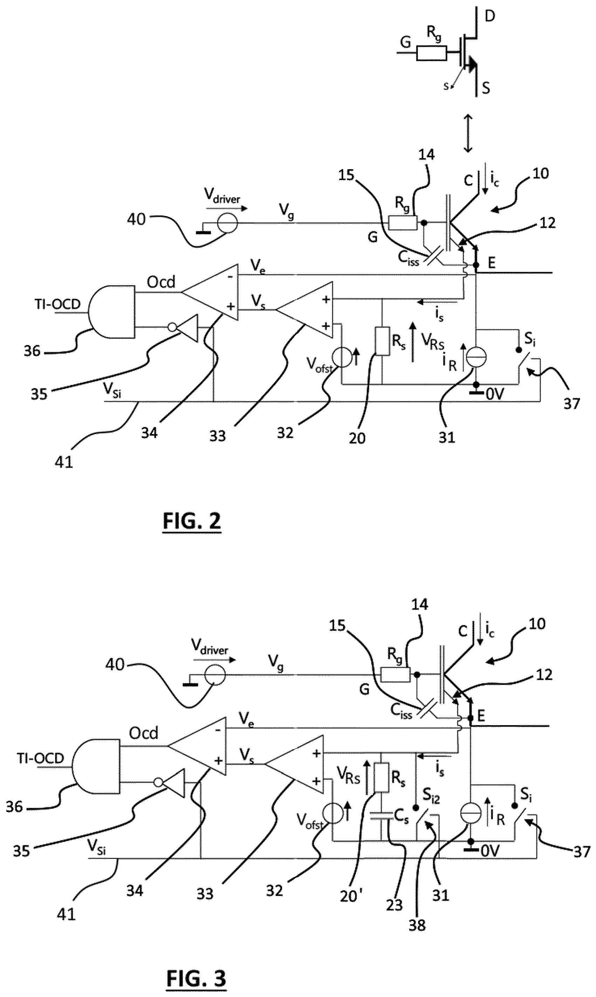

Figure 2 shows a semiconductor switch 10 such as an IGBT provided with a first example of an overcurrent detection circuit.

In this example is shown that the IGBT may be replaced by a MOSFET shown on top of the figure where the emitter E of the IGBT being replaced by the source of the MOSFET, the collector of the IGBT being replaced by the drain of the MOSFET and the current mirror output being linked to the source of the MOSFET instead of the emitter of the IGBT.

The detection circuit comprises a compensation circuit configured to compensate a temperature dependency of a built-in current mirror of said power semiconductor switch 10 , said current mirror output 12 being connected to a measurement resistor Rs 20, connected between said current mirror output and a low voltage level of a driver voltage source 40 to provide a voltage $V_{Rs} = i_s \cdot Rs$.

It should be noted that in case of a half-bridge, the schematics of figure 2 corresponds to an upper branch switch and in case of a lower branch switch the low voltage level would be the lower voltage of the lower branch switch.

The current mirror output and the resistor are connected together to an adder 33 having a second adder input receiving an offset $V_{ofst}$ 32, to provide a mirror voltage $Vs = V_{Rs} + V_{ofst}$.

The adder providing a mirror voltage Vs mirroring the current Ic flowing through the power switch collector-emitter or drain-source junction.

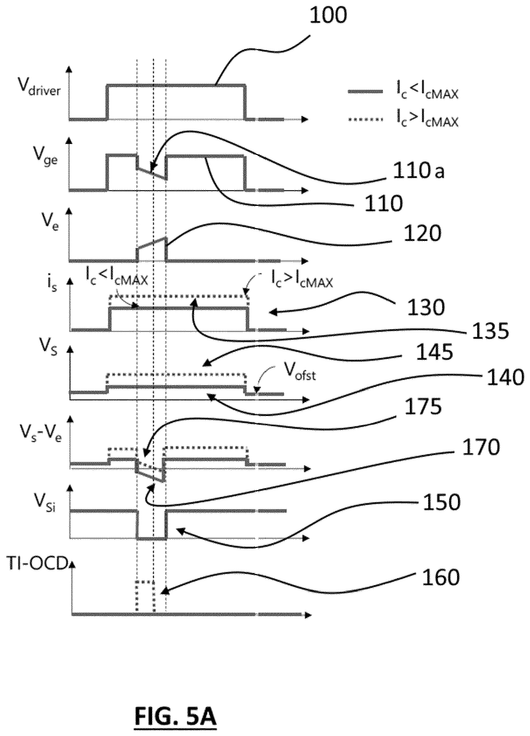

The compensation circuit comprises a current source 31 configured to provide a reference current $i_R$, such current source being connected to a temperature sensitive element, which is in this example the gate resistor Rg 14 of the power semiconductor switch, in which said reference current $i_R$ flows during at least a dedicated period of measurement as will be seen in correspondence with figure 5A.

The current $i_R$, flowing through the temperature sensitive element 14 in figure 2 provides a reference voltage Ve which is input at a comparator 34 having at its other input the voltage Vs in order to compare said reference voltage Ve and said mirror voltage Vs. With this configuration, the compensation circuit is configured to provide at an output of the comparator 34 a detection signal Ocd changing its state when said mirror voltage exceeds said reference voltage Ve.

In this example, the temperature sensitive element being the internal gate resistor Rg 14 of the semiconductor switch, the current source is connected to such gate resistance Rg 14 through the power emitter E or the Kelvin emitter output in case of the IGBT represented on the drawing or the source of the MOSFET switch such as shown above the IGBT on the drawing, in a way that said reference current $i_R$ flows through the gate resistance Rg 14 to provide the reference voltage Ve, which is compared at the comparator 34 with said mirror voltage Vs.

The measurement period during which the reference current $i_R$ is injected in the gate resistance is defined by the switch 37 in parallel with the current source. When the switch 37 is open it allows the current $i_R$ generated by the current generator 31 to flow in the gate resistance. When the switch 37 is closed it shunts the current source 31 and stops the current flowing through the resistance outside the measurement period.

The switch 37 is opened and closed with a command signal line 41 providing a command signal $V_{SI}$ shown in curve 150 in figure 5A. Still in figure 5A, the dedicated period is made with $V_{SI}$ pulse within a ON period of the semiconductor switch driven by a driver voltage $V_{driver}$ as in curve 100.

The current $I_R$ is injected through the gate to emitter of the die. It crosses the internal gate resistor Rg and the input capacitance Ciss. In figure 5A, the result causes a drop 110a in the $V_{GE}$ curve 110 and provides the voltage Ve in curve 120 which comprises the voltage drop across Rg subject to $I_R$ and which is sent to the comparator 34.

The current sensor output $i_S$ is shown in curve 130 in solid line for an emitter collector current of the switch under the overcurrent limit and in curve 135 in dotted line for an emitter-collector current above the overcurrent limit. Such current is crossing the sense resistor Rs to provide a voltage $V_{Rs}$.

The voltage across Rs is added to the offset voltage $V_{ofst}$. The result of this addition is the voltage Vs in figure 5A, the sensed voltage, which is an image of the sensed current without overcurrent in curve 140 and with overcurrent in curve 145.

The voltages Ve and Vs are compared in the comparator 34 as shown in figure 5A as Vs-Ve and If Vs is superior to Ve in the detection period as in curve 175, even for small duration, an over-current is detected. Such over-current corresponds to the square signal TI-OCD 160 in dotted line in correspondence with the detection period Vsi curve 150. In case no overcurrent exist, the curve Vs-Ve in the detection period remains under zero as in curve 170.

The previously described circuit allows to monitor the over-current only at specific moments when a current $i_R$ is injected through the gate. Before that instant, when there is no current injected, the value at the output of the comparator is positive. It can easily be discarded by a logical AND gate 36 combination. For instance, an over-current is detected if the output of the comparator is high AND the signal in line 41 that controls the injection is high. Other possibilities of logical gates designs are possible depending on the type of logic available.

Starting from the formulas above it can be said that:

At the very beginning instant of the current injection:

$$Ve = Rg \cdot i_R$$

Assuming *Vs* is complemented by an additional offset voltage, we have :

$$Vs - Ve = Rs \cdot A \cdot i_c + V_{ofst} - R_0 \cdot i_R + Rs \cdot B \cdot Tj \cdot i_c - \alpha \cdot T_j \cdot i_R$$

To obtain a temperature independency of the over-current threshold $i_c = i_{cMAX}$ :

$$(Rs \cdot B \cdot Tj \cdot i_c - \alpha \cdot T_j \cdot i_R) = 0 \Rightarrow i_R = \frac{B \cdot Rs \cdot i_{cMAX}}{\alpha}$$

To have *Vs - Vg* =0 when $i_c = i_{cMAX}$:

$$V_{ofst} = -i_{cMAX} \cdot Rs \cdot \left(A - \frac{R_0 \cdot B}{\alpha}\right)$$

Typical values and results are:

| | |
|---|---|
| *A* | 8.0895e-06 |
| *B* | 1.0195e-07 |
| *Rs* | 160 Ω |
| $R_0$ | 13 Ω |

(continued)

| $\alpha$ | 0.013 Ω/K |
|---|---|
| $i_{cMAX}$ | 100A |
| $i_i$ | 125.5 mA |
| $V_{ofst}$ | 1.5018 V |

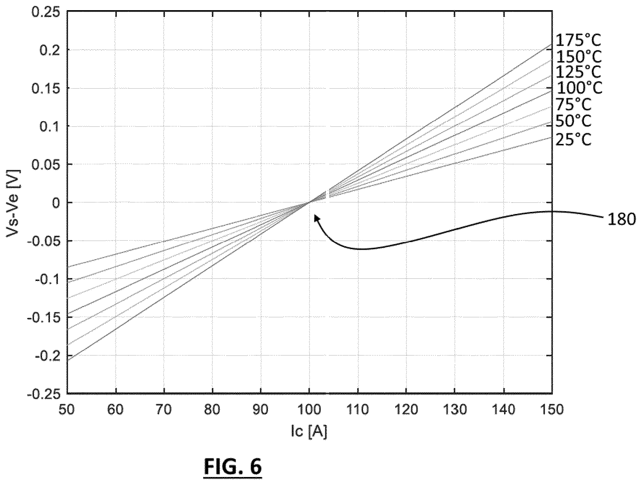

With the above numerical values, the crossing point of *Vs* and *Ve* occurs at 100A independently of the junction temperature as shown in figure 6 in point 180 on a curve (Vs-Ve) plotted against Ic for different temperatures. In such example, the overcurrent detector is insensitive to the temperature at $i_C = i_{cMAX} = 100\,A$. The sensitivity of the comparison is > 10 mV for 6 A error and increases at high temperature.

As can be seen the compensation obtained by the present disclosure design is very good at a specified current and still correct for currents around such specified current.

Figure 3 shows a second example which is based on the example of figure 2 but in which a capacitor $C_S$ 23 is added between the resistor Rs 20' and the low voltage level of the circuit to generate a trapezoidal voltage shape $V_S$ with a positive voltage ramp but lower than the one of Vg. Thus, in case of over-current, the output of the comparator is high for a longer time. In such case it is necessary to discharge the capacitor $C_S$ and this is done with a further switch 38 which can also be triggered by the $V_{SI}$ signal 41.

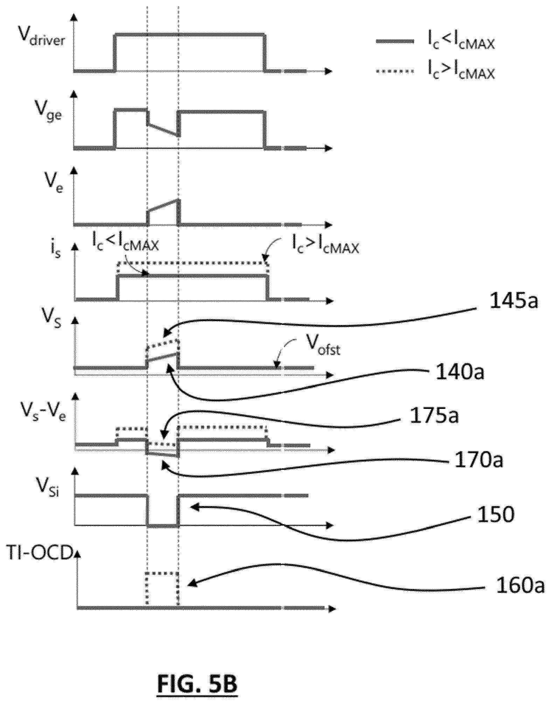

The resulting curves are shown in figure 5B where it can be seen that Vs in curve 140a without overcurrent and 145a with overcurrent being ramped in the detection period causes a higher Vs-Ve curve 175a when the overcurrent is present causing in turn a longer detection 160a in the detection period Vsi 150.

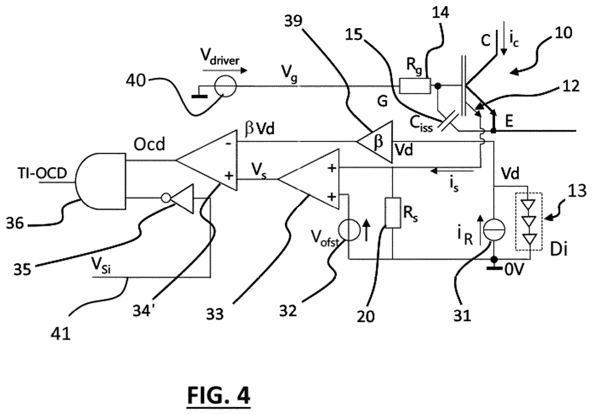

Figure 4 shows another design where the temperature is estimated from small diodes Di 13 built-in the die of the semiconductor switch as in figure 1. When a DC current $i_R$ is injected through these diodes, the voltage drop is sensitive to the temperature.

For a constant pre-defined current, the voltage drop across the sensing diode may be expressed as a linear relation with temperature:

$$V_T = V_0 - \alpha \cdot Tj$$

Assuming this voltage drop can be scaled by a parameter β, for example with a voltage divider or a multiplier circuit 39 using an operational amplifier, the following relation can be obtained:

$$Vs + VT = Rs \cdot A \cdot ic + Vofst + V_0 \cdot \beta + Rs \cdot B \cdot Tj \cdot ic - \alpha \cdot Tj \cdot \beta$$

To obtain a temperature independency of the over-current threshold:

$$i_c = i_{cMAX} : (Rs \cdot B \cdot Tj \cdot ic - \alpha \cdot Tj \cdot \beta) = 0 \Rightarrow \beta = B \frac{B \cdot Rs \cdot i_{cMAX}}{\alpha}$$

in order to have *Vs + VT* =0 when ic= $i_{cMAX}$:

$$V_{ofst} = -i_{cMAX} \cdot Rs \cdot (A + V_0)$$

In such design, the current source is not connected to the IGBT or MOSFET but to the diodes 13 and the voltage Vd at the pins of the diodes is amplified with amplifier 39 and the result βVd is compared to the output Vs as in the design of figure 1.

This design depending on the presence of the diodes Di simplifies the circuit as there is no need to shunt the current source 31.

Concerning the first and second examples, during the injection, the presence of Ciss 15 is responsible for the increase of Ve, and the pull-down of the TI-OCD signal. An over-current is thus detected if the signal TI-OCD becomes high, even for a small moment. A low-cost component may be advantageously used to latch this signal and increase the robustness and detectability of the detection.

In practice, a too small moment may be filtered by the electronic circuit, and it is necessary to define the value of $V_{ofst}$ such that it triggers at the value of the over-current threshold. For this, a calibration method can be used. A current pulse with a value $i_{cMAX}$ can be imposed to the die in on-state. The length of this pulse is generally short (i.e. less than 1s) to prevent any excessive self-heating. The offset voltage $V_{ofst}$ is then increased until the detection of a TI-OCD. The corresponding value of $V_{ofst}$ is defined and applied. The result of this calibration is mostly dependent on the electronic circuit implementation of the TI-OCD. After being performed once, it can be applied to other circuits, even if used with other power modules.

Thus, the identification of the parameter $V_{ofst}$ is practical and low-cost.

The value of $i_R$ is less sensitive to the circuit implementation. Prior knowledge of the temperature sensitivity of the built-in current sensor and of the internal gate resistor is required and can be performed easily with conventional measurement set-ups.

It is sometimes required to continuously monitor the over-current. In this case, the temperature-dependent over-current can be measured directly across $R_S$ 20, 20', i.e., without the temperature correction or at the output of the adder 33. If an over-current is detected, a temperature-independent over-current estimation can be instantaneously triggered to verify if the detection is an artefact of the temperature or a real over-current detection.

Thus, both a continuous and a temperature over-current detection can be achieved.

This disclosure is not limited to the examples described here and in example in case other temperature dependent components are present on the semiconductor switch die, such may be used instead of the diodes 13.

**Claims**

1. Semiconductor switch (10) such as an IGBT or a MOSFET equipped with an overcurrent detection circuit said detection circuit comprising a compensation circuit configured to at least partly compensate a temperature dependency of a built-in current mirror (12) output of said power semiconductor switch (10), said compensation circuit comprising a measurement resistor Rs (20, 20') connected , between a current mirror output of said semiconductor switch and a low voltage level of the driver voltage source (40) to provide a detection voltage $V_{Rs}=i_S \cdot Rs$ where $i_S$ is a current output from said current mirror output, said current mirror output being connected further to a first adder input having a second adder input receiving an offset voltage $V_{ofst}$ (32) to provide a mirror voltage $V_S=V_{Rs} + V_{ofst}$, wherein said compensation circuit comprises a current source (31) configured to provide a reference current $i_R$ and connected to a temperature sensitive element (13, 14) of said power semiconductor switch in which said reference current $i_R$ flows during at least a dedicated period of measurement through said temperature sensitive element (13, 14) to provide a first reference voltage Ve or a second reference voltage Vd, said compensation circuit comprising further a comparator (34, 34'), comparing said first reference voltage Ve or an amplified second reference voltage βVd and said mirror voltage $V_{Rs}$ and wherein said offset voltage $V_{ofst}$ is adapted to said first reference voltage Ve or said second reference voltage Vd of said compensation circuit to provide at an output of said comparator a detection signal Ocd changing its state from an OFF state to a ON state when a current in said semiconductor switch is over a specified level $i_{cMAX}$ causing said mirror voltage Vs exceed said reference voltage Ve or said amplified reference voltage βVd, said detection signal Ocd providing said overcurrent detection and wherein said temperature sensitive element being a gate resistor Rg (14) of said semiconductor switch, said current source is connected to said gate resistance Rg (14) of said power semiconductor switch through an emitter or source of said semiconductor switch, in a way that said reference current $i_R$ flows during said at least dedicated period of measurement through said gate resistance Rg (14) to provide said reference voltage Ve, said comparator (34), comparing said reference voltage Ve and said mirror voltage Vs.

2. Semiconductor switch (10) such as an IGBT or a MOSFET equipped with an overcurrent detection circuit as claimed in claim 1 wherein said current source is configured in parallel with a switch in order to shunt said current source (31) with a command signal line (41) providing a command signal $V_{SI}$ to inhibit flowing of said reference current $i_R$ in said gate resistor outside of said dedicated period of measurement, said dedicated period being made of a pulse within a ON period of the semiconductor switch driven by a driver voltage $V_{driver}$.

3. Semiconductor switch (10) such as an IGBT or a MOSFET equipped with an overcurrent detection circuit as claimed in claim 2 wherein the measurement resistor Rs (20') is connected to the low voltage level of the driver voltage source (40) through a capacitor Cs (23) forming a charging circuit provided to generate the mirror voltage Vs with a trapezoidal voltage shape having a positive voltage ramp lower than the gate voltage Vg, said charging circuit comprising a reset switch (38) connected to said charging circuit to discharge said capacitor Cs (23) and connected to said command signal line (41).

4. Semiconductor switch (10) such as an IGBT or a MOSFET equipped with an overcurrent detection circuit as claimed in any one of claims 1 to 3 comprising a logic gate (36) receiving said detection signal Ocd and a measurement inhibition signal line providing an inhibition signal to inhibit false detections outside of said dedicated measurement period, said logic gate providing an overcurrent detection logic signal TI-OCD.

5. Semiconductor switch (10) such as an IGBT or a MOSFET equipped with an overcurrent detection circuit according to claims 2 or 3 and claim 4 wherein said measurement inhibition signal line is said command signal line (41).

6. Command circuit for a semiconductor switch comprising an overcurrent detection circuit as claimed in any one of claims 1 to 5 wherein said overcurrent detection circuit is connected to an overcurrent detection input of said command circuit, said command circuit being configured to switch OFF said semiconductor switch upon occurrence of an overcurrent.

**Patentansprüche**

1. Halbleiterschalter (10), wie beispielsweise ein IGBT oder ein MOSFET, welcher mit einer Überstrom-Detektionsschaltung ausgerüstet ist, wobei die Detektionsschaltung eine Kompensationsschaltung umfasst, welche dazu eingerichtet ist, wenigstens teilweise eine Temperaturabhängigkeit einer eingebauten Stromspiegel (12)-Ausgabe des Leistung-Halbleiterschalters (10) zu kompensieren, wobei die Kompensationsschaltung einen Messwiderstand Rs (20, 20') umfasst, welcher zwischen einer Stromspiegel-Ausgabe des Halbleiterschalters und einem Niederspannung-Pegel der Treiber-Spannungsquelle (40) verbunden ist, um eine Detektionsspannung $V_{Rs}=i_S \cdot R_s$ bereitzustellen, wobei $I_S$ ein Strom ist, welcher von der Stromspiegel-Ausgabe ausgegeben wird, wobei die Stromspiegel-Ausgabe ferner mit einer ersten Addierer-Eingabe verbunden ist, welche eine zweite Addierer-Eingabe aufweist, welche eine Offset-Spannung $V_{ofst}$ (32) erhält, um eine Spiegelspannung $V_s=V_{Rs}+V_{ofst}$ bereitzustellen, wobei die Kompensationsschaltung eine Stromquelle (31) umfasst, welche dazu eingerichtet ist, einen Referenzstrom $i_R$ bereitzustellen, und mit einem temperaturempfindlichen Element (13, 14) des Leistung-Halbleiterschalters verbunden ist, wobei der Referenzstrom $i_R$ während wenigstens einer dedizierten Messperiode durch das temperaturempfindliche Element (13, 14) fließt, um eine erste Referenzspannung Ve oder eine zweite Referenzspannung Vd bereitzustellen, wobei die Kompensationsschaltung ferner einen Komparator (34, 34') umfasst, welcher die erste Referenzspannung Ve oder eine verstärkte zweite Referenzspannung βVd und die Spiegelspannung $V_{Rs}$ vergleicht, und wobei die Offset-Spannung $V_{ofst}$ auf die erste Referenzspannung Ve oder die zweite Referenzspannung Vd der Kompensationsschaltung angepasst ist, um an einer Ausgabe des Komparators ein Detektionssignal Ocd bereitzustellen, welches seinen Zustand von einem AUSZustand zu einem AN-Zustand ändert, wenn ein Strom in dem Halbleiterschalter über einem spezifizierten Pegel $i_{cMAX}$ liegt, was dazu führt, dass die Spiegelspannung Vs die Referenzspannung Ve oder die verstärkte Referenzspannung βVd übersteigt, wobei das Detektionssignal Ocd die Überstrom-Detektion bereitstellt, und wobei das temperaturempfindliche Element ein Gate-Widerstand Rg (14) des Halbleiterschalters ist, wobei die Stromquelle mit dem Gate-Widerstand Rg (14) des Leistung-Halbleiterschalters durch einen Emitter oder eine Source des Halbleiterschalters derart verbunden ist, dass der Referenzstrom $i_R$ wenigstens während der dedizierten Messperiode durch den Gate-Widerstand Rg(14) fließt, um die Referenzspannung Ve bereitzustellen, wobei der Komparator (34) die Referenzspannung Ve und die Spiegelspannung Vs vergleicht.

2. Halbleiterschalter (10), wie beispielsweise ein IGBT oder ein MOSFET, welcher mit einer Überstrom-Detektionsschaltung ausgerüstet ist, nach Anspruch 1, wobei die Stromquelle parallel mit einem Schalter eingerichtet ist, um die Stromquelle (31) mit einer Anweisungssignal-Leitung (41) nebenzuschließen, welche ein Anweisungssignal $V_{SI}$ bereitstellt, um ein Fließen des Referenzstroms $i_R$ in dem Gate-Widerstand außerhalb der dedizierten Messperiode zu verhindern, wobei die dedizierte Periode aus einem Puls innerhalb einer AN-Periode des Halbleiterschalters besteht, welcher von einer Treiberspannung $V_{driver}$ getrieben wird.

3. Halbleiterschalter (10), wie beispielsweise ein IGBT oder ein MOSFET, welcher mit einer Überstrom-Detektionsschaltung ausgerüstet ist, nach Anspruch 2, wobei der Messwiderstand Rs (20') mit dem Niederspannung-Pegel der Treiber-Spannungsquelle (40) durch einen Kondensator Cs (23) verbunden ist, welcher eine Ladeschaltung bildet, welche bereitgestellt ist, um die Spiegelspannung Vs mit einer trapezförmigen Spannungsform zu erzeugen, welche eine positive Spannungsrampe aufweist, welche niedriger als die Gate-Spannung Vg ist, wobei die Ladeschaltung einen Rücksetzschalter (38) umfasst, welcher mit der Ladeschaltung verbunden ist, um den Kondensator Cs (23) zu entladen, und mit der Anweisungssignal-Leitung (41) verbunden ist.

4. Halbleiterschalter (10), wie beispielsweise ein IGBT oder ein MOSFET, welcher mit einer Überstrom-Detektionsschaltung ausgerüstet ist, nach einem der Ansprüche 1 bis 3, umfassend ein Logik-Gate (36), welches das Detektionssignal Ocd erhält, und eine Messung-Verhinderungssignal-Leitung, welche ein Verhinderungssignal bereitstellt, um falsche Detektionen außerhalb der dedizierten Messperiode zu verhindern, wobei das Logik-Gate ein Überspannungsdetektion-Logiksignal TI-OCD bereitstellt.

5. Halbleiterschalter (10), wie beispielsweise ein IGBT oder ein MOSFET, welcher mit einer Überstrom-Detektionsschaltung ausgerüstet ist, nach Anspruch 2 oder 3 und Anspruch 4, wobei die Messung-Verhinderungssignal-Leitung die Anweisungssignal-Leitung (41) ist.

6. Anweisungsschaltung für einen Halbleiterschalter, welcher eine Überstrom-Detektionsschaltung umfasst, nach einem der Ansprüche 1 bis 5, wobei die Überstrom-Detektionsschaltung mit einer Überstrom-Detektionseingabe der Anweisungsschaltung verbunden ist, wobei die Anweisungsschaltung dazu eingerichtet ist, den Halbleiterschalter auf ein Auftreten eines Überstroms hin AUSzuschalten.

**Revendications**

1. Interrupteur à semi-conducteur (10) tel qu'un IGBT ou un MOSFET équipé d'un circuit de détection de surintensité, ledit circuit de détection comprenant un circuit de compensation configuré pour compenser au moins partiellement une dépendance à la température d'une sortie d'un miroir de courant intégré (12) dudit interrupteur à semi-conducteur de puissance (10), ledit circuit de compensation comprenant une résistance de mesure Rs (20, 20') connectée, entre une sortie de miroir de courant dudit interrupteur à semi-conducteur et un niveau basse tension de la source de tension de pilotage (40) pour fournir une tension de détection $V_{RS} = i_s \cdot RS$ où $i_S$ est un courant de sortie issu de ladite sortie de miroir de courant, ladite sortie de miroir de courant étant connectée en outre à une première entrée d'additionneur ayant une deuxième entrée d'additionneur recevant une tension de décalage $V_{ofst}$ (32) pour fournir une tension de miroir $Vs = V_{Rs} + V_{ofst}$, dans lequel ledit circuit de compensation comprend une source de courant (31) configurée pour fournir un courant de référence $i_R$ et connectée à un élément sensible à la température (13, 14) dudit interrupteur à semi-conducteur de puissance dans lequel ledit courant de référence $i_R$ circule pendant au moins une période de mesure dédiée à travers ledit élément sensible à la température (13, 14) pour fournir une première tension de référence Ve ou une deuxième tension de référence Vd, ledit circuit de compensation comprenant en outre un comparateur (34, 34') comparant ladite première tension de référence Ve ou une deuxième tension de référence amplifiée $\beta Vd$ et ladite tension miroir $V_{RS}$ et dans lequel ladite tension de décalage $V_{ofst}$ est adaptée à ladite première tension de référence Ve ou à ladite deuxième tension de référence Vd dudit circuit de compensation pour fournir au niveau d'une sortie dudit comparateur un signal de détection Ocd changeant son état d'un état ARRÊT à un état MARCHE lorsqu'un courant dans ledit interrupteur à semi-conducteur est supérieur à un niveau spécifié $i_{cMAX}$ entraînant le dépassement, par ladite tension miroir Vs, de ladite tension de référence Ve ou de ladite tension de référence amplifiée $\beta Vd$, ledit signal de détection Ocd fournissant ladite détection de surintensité et dans lequel ledit élément sensible à la température étant une résistance de grille Rg (14) dudit interrupteur à semi-conducteur, ladite source de courant est connectée à ladite résistance de grille Rg (14) dudit interrupteur à semi-conducteur de puissance par l'intermédiaire d'un émetteur ou d'une source dudit interrupteur à semi-conducteur, de manière à ce que ledit courant de référence $i_R$ circule pendant au moins ladite période de mesure dédiée à travers ladite résistance de grille Rg (14) pour fournir ladite tension de référence Ve, ledit comparateur (34) comparant ladite tension de référence Ve et ladite tension miroir Vs.

2. Interrupteur à semi-conducteur (10) tel qu'un IGBT ou un MOSFET équipé d'un circuit de détection de surintensité selon la revendication 1, dans lequel ladite source de courant est configurée en parallèle avec un interrupteur afin de shunter ladite source de courant (31) avec une ligne de signal de commande (41) fournissant un signal de commande $V_{SI}$ pour inhiber la circulation dudit courant de référence $i_R$ dans ledit résistor de grille en dehors de ladite période de mesure dédiée, ladite période dédiée étant constituée d'une impulsion au sein d'une période MARCHE de l'interrupteur à semi-conducteur piloté par une tension de pilotage $V_{driver}$.

3. Interrupteur à semi-conducteur (10) tel qu'un IGBT ou un MOSFET équipé d'un circuit de détection de surintensité selon la revendication 2 dans lequel la résistance de mesure Rs (20') est connectée au niveau basse tension de la source de tension de pilotage (40) à travers un condensateur Cs (23) formant un circuit de charge prévu pour générer la tension miroir Vs avec une forme de tension trapézoïdale ayant une rampe de tension positive inférieure à la tension de grille Vg, ledit circuit de charge comprenant un interrupteur de réinitialisation (38) connecté audit circuit de charge pour décharger ledit condensateur Cs (23) et connecté à ladite ligne de signal de commande (41).

4. Interrupteur à semi-conducteur (10) tel qu'un IGBT ou un MOSFET équipé d'un circuit de détection de surintensité selon l'une quelconque des revendications 1 à 3 comprenant une porte logique (36) recevant ledit signal de détection Ocd et une ligne de signal d'inhibition de mesure fournissant un signal d'inhibition pour inhiber de fausses détections en dehors de ladite période de mesure dédiée, ladite porte logique fournissant un signal logique de détection de surintensité TI-OCD.

5. Interrupteur à semi-conducteur (10) tel qu'un IGBT ou un MOSFET équipé d'un circuit de détection de surintensité selon les revendications 2 ou 3 et la revendication 4 dans lequel ladite ligne de signal d'inhibition de mesure est ladite ligne de signal de commande (41).

6. Circuit de commande pour un interrupteur à semi-conducteur comprenant un circuit de détection de surintensité selon l'une quelconque des revendications 1 à 5 dans lequel ledit circuit de détection de surintensité est connecté à une entrée de détection de surintensité dudit circuit de commande, ledit circuit de commande étant configuré pour éteindre ledit interrupteur à semi-conducteur lors de la survenue d'une surintensité.

**FIG. 1**

**FIG. 2**

**FIG. 3**

**FIG. 4**

**FIG. 5A**

**FIG. 5B**

**FIG. 6**

## REFERENCES CITED IN THE DESCRIPTION

**Patent documents cited in the description**

- US 2018281600 A1